# EUROPEAN PATENT SPECIFICATION

(11) **EP 2 271 195 B1**
(45) Date of publication and mention of the grant of the patent: **09.02.2011**
(21) Application number: 09008476.5
(22) Date of filing: 29.06.2009
(51) Int. Cl.: H05K 5/04

(54) **Casing for a front cover of a household appliance**
Gehäuse für die Frontabdeckung eines Haushaltsgeräts
Boîtier pour le panneau avant d'un appareil domestique

(43) Date of publication of application: 05.01.2011
(73) Proprietor: Electrolux Home Products Corporation N.V., 1930 Zaventem (BE)
(72) Inventor: Deib, Hans, 91616 Neusitz (DE); Kranz, Willi, 91625 Schnelldorf (DE); Lyko, Franziska, 96450 Coburg (DE); Winkelmann, Klaus, 63688 Gedern (DE); Feser, Jürgen, 90763 Fürth (DE); Meißner, Heiko, 90547 Stein (DE)
(74) Representative: Hochmuth, Jürgen

(56) References cited:
- DE-A1-102004 012 253
- FR-A1- 2 419 651
- US-A1- 2004 124 194

## Description

The present invention relates to a casing for a front cover of a household appliance, having at least one front wall, one longitudinal wall and one lateral wall, wherein the front wall, the longitudinal wall and the lateral wall form a corner of the casing, the longitudinal wall comprises a longitudinal flange and a joint flange which is bent off and forms a butt joint with the lateral wall and the lateral wall comprises a lateral flange and wherein at least one retaining portion is provided on one of the flanges and at least one fastening portion is provided on the other flange, each flange is bent off rectangular and extending parallel to the front wall, such that the casing constitutes a box like form.

DE 10 2004 012 253 A1 describes a casing made of bendable material, comprising a bottom wall and side walls arranged rectangular to the bottom wall, characterized in that the side walls comprise in the region of the upper corners a flange, that is bent off rectangular and extending parallel to the bottom wall, wherein flange and side walls or only the flange comprise recesses wherein lugs equal in form engage for fixation of the side walls. Such an arrangement has to be carried out very precisely and does not comprise any possibility to adjust the side walls and the bottom walls relative to each other. Therefore the tolerances for the lugs and the recesses have to be met precisely. Furthermore the lugs and recesses would be at least partially visible for a user, which would cause an unaesthetic appearance.

DE 10 2007 031 479 A1 describes a household appliance, provided with at least one operation module, which has at least one operation cover made from a metallic material. The operation cover is formed seamless. Such an arrangement does also not comprise any parts for adjusting the positions of the front portion and the top portion of the operation cover relative to each other. Furthermore the operation cover is designed especially for a bending with a larger radius.

DE 196 49 047 C2 describes a household appliance having an operation cover with a front surface where at least one operation element for operating the household appliance is arrangeable and with at least one fastening element, which is arranged behind the front surface and covered in the viewing direction to the front surface, and a supporting arrangement for supporting the at least one fastening element of the operation cover. Such an operation cover also does not comprise means for adjusting the side walls and the front wall relative to each other.

In all known casings, front covers or operation panels described in the aforementioned documents, there are no means or arrangements for stabilising the corner of a casing in a way that adjustment of the relative positions of the front wall and the lateral walls is enabled.

An object of the present invention is to create an improved casing of the said kind.

A solution of this object according to the invention is defined and characterized by a casing according to claim 1 and a method for producing a casing according to claim 11. The dependent claims refer to further embodiments of the present invention.

According to the present invention the fastening portion comprises a fastening leg, that is extending angular relative to the planes defined by the flanges and the retaining portion comprises a retaining recess that is extending relative to the planes defined by the flanges, whereas the fastening leg engages into the retaining recess and applies a force to the retaining portion, so that the lateral wall, the longitudinal wall and the front wall are fixed in their position relative to each other, wherein the force is applied by the fastening leg when in contact with the retaining portion causing a traction such that the joint flange and the lateral wall are pressed together. Thus, the corner of the casing, that is formed by the lateral wall, the longitudinal wall and the front wall is stabilized and the walls are fixed in their position relative to each other. The worker is enabled to adjust the positions of the walls relative to each other by varying the applied force. An arrangement of the walls in a precise way can be achieved even when the pre-cut metal sheet is not meeting the tolerances. Parallel extension of the flanges simplifies the production of the casing and makes it easier to adjust the walls in their positions relative to each other.

According to an advantageous embodiment of the invention the lateral wall, the longitudinal wall and the front wall are fixed in a rectangular position relative to each other. For the use of the casing within the visible front of a household appliance, a precise rectangular form of the casing is ideal. Also other forms, depending on the desired design, are imaginable and can be realized by the use of the present invention.

According to another advantageous embodiment of the invention the force is adjusted to the material the cover is made of. The force can be determined according to the material the cover is made of or to the coating of the material. Different materials can be employed such as stainless steel, galvanized or pre-coated metals or plastics.

According to another advantageous embodiment of the invention the longitudinal wall comprises a joint flange that is bent off rectangular into a recess comprised by the lateral wall and that is forming a butt joint with the lateral wall. Having such a joint flange and butt joint, the corner between lateral wall and longitudinal wall is not provided with the ends of the lateral wall and the longitudinal wall meeting at the corner. There is provided a transition at the corner with a bending radius comprised by the joint flange and the ends of the lateral wall and the longitudinal wall are meeting in a butt joint. Thus, the ends are not visible for a user and protected from corrosion.

According to a further advantageous embodiment of the invention the force is adjusted in such a way, that the butt joint is formed without a gap. The forming of the butt joint without a gap improves the protection from corrosion even more. Further the interior of the casing is protected from the ingress of moisture or filth or the like.

According to another advantageous embodiment of the invention the lateral flange and/or the longitudinal flange comprise one or more connection elements for connecting electronic components or operating buttons or the like to the casing or for connecting the casing to the household appliance. By means of such connection elements the casing can be mounted to a household appliance whereas the connection elements are not visible. Easy mounting of additional devices such as electronic components or operating buttons is enabled.

According to a further advantageous embodiment of the invention the connection element or connection elements for connecting the casing to another component or the household appliance are provided with at least one embossment for stabilizing the connection. Such embossments reinforce the structure of the casing and simultaneously the connection of the casing to the household appliance.

According to another advantageous embodiment of the invention the bending of the longitudinal wall and/or the upper front edge comprise a radius equal or smaller than twice the thickness of the metal sheet at these positions. Corners of casings that have a radius equal or smaller than twice the thickness of the wall that is bended at this positions give the designer a wide range of possibilities to adapt the appearance of the casing to the design of the household appliance. Small radii usually give an elegant impression and a good haptic.

According to another advantageous embodiment of the invention the fastening leg and the retaining recess extend into the interior of the casing. Thus, the back wall of the casing can be mounted to the household appliance without forming a gap between the casing and the household appliance. According to another the force that is applied by the fastening leg to the retaining portion is a predefined resilient force. Parts like the walls of the casing that are established by bending processes comprises always resilient forces which take effect in opposition to the bending direction. Taken this effect into account before, the resilient force of the fastening leg can be predefined. Thus, the exact positioning of the walls can be achieved.

An alternative solution for the object is given by the method for forming a front cover of a household appliance, comprising the steps die cutting of one metal sheet to two-dimensional structure, wherein at least one retaining portion having a recess and one fastening portion having a fastening leg are produced, bending for constituting lateral walls, longitudinal walls, lateral flanges and longitudinal flanges, wherein at least one corner is constituted comprising the recess and the fastening leg, engaging of the fastening leg into the recess by a bending operation, wherein a defined force is applied to the fastening leg, so that the joint between longitudinal wall and lateral wall is formed without a gap. This solution comprises a method for producing a casing with low costs and enabling an arrangement of the walls in a precise way.

According to a further advantageous embodiment of the present invention the force to be applied to the fastening leg is defined after measuring dimensions and positions of the fastening leg and the recess. Thus, tolerances can be compensated by determining the applied force according to a preceding measurement.

An embodiment of the invention is further disclosed by the following description according to the drawings.
Fig 1 is a perspective view of a casing, in particular for the use as a front cover of a household appliance showing a front side as well as a back side;
Fig 2 is a rear view of a casing embodying the invention, showing a corner of the casing in an assembled state;
Fig 3 is an enlarged view of a corner according to Fig 2 embodying the invention;
Fig 4 is a wall view from the left of a casing embodying the invention;
Fig 5 is sectional wall view from the left according to Fig 4;

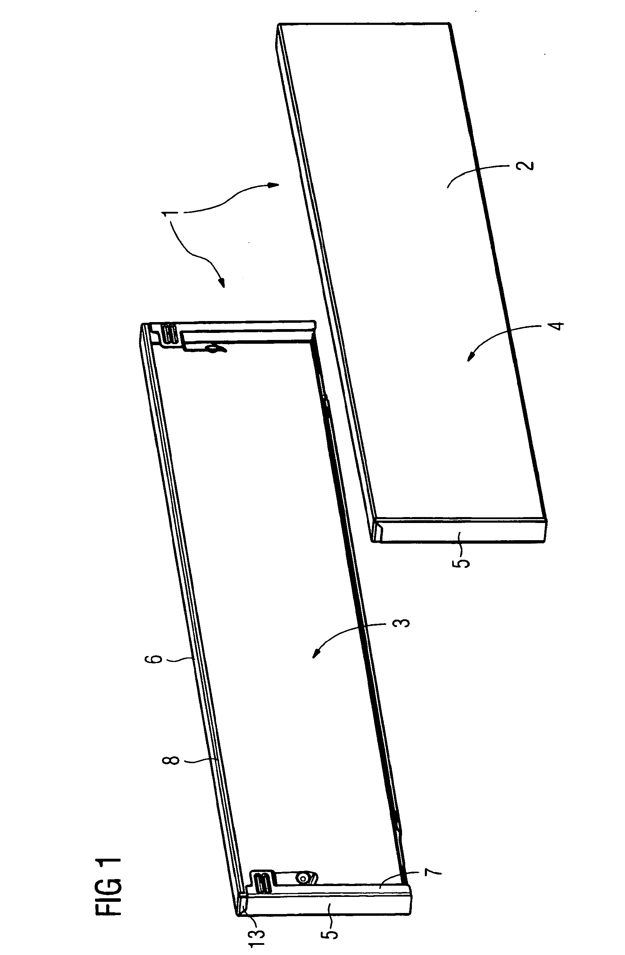

In Fig 1 it is shown a front side 4 and a back side 3 of a casing 1, wherein the front side 4 is forming the front wall 2. The casing 1 comprises a lateral wall 5 and a longitudinal wall 6, wherein the lateral wall 5 has a lateral flange 7 and the longitudinal wall 6 has a longitudinal flange 8. The lateral flange 7 and the longitudinal flange 8 are extending substantially parallel to the front wall 2, respectively to the back wall 3 of the casing 1. Thus, the casing 1 constitutes a box like form. Both flanges are extending substantially parallel to the front wall 2, respectively to the back wall 3. Further it is shown a joint flange 13, which is described later.

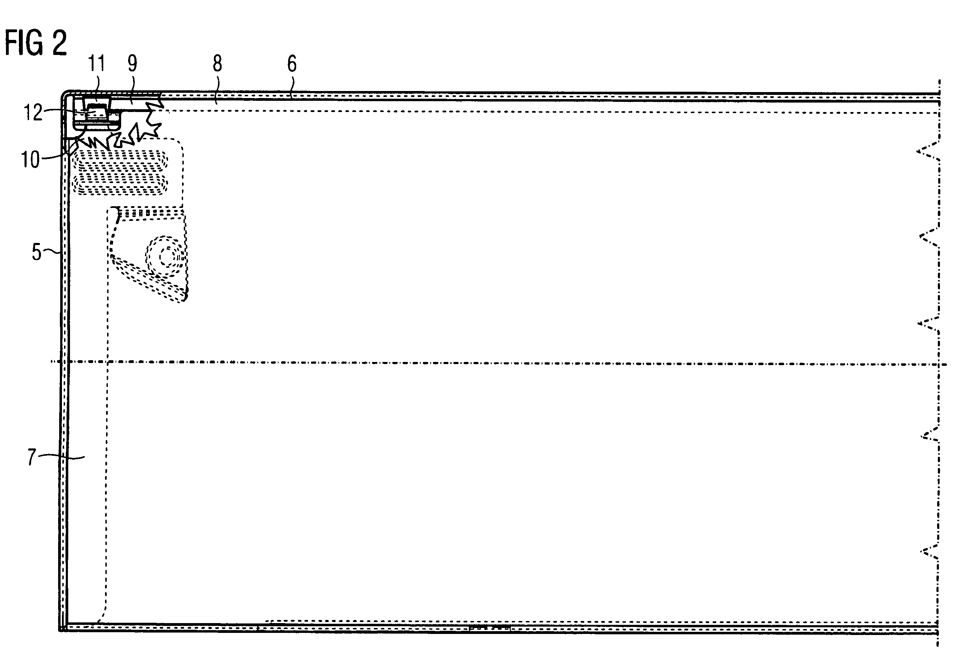

Fig 2 shows the back side of a casing 1 having the lateral wall 5, the longitudinal wall 6, the lateral flange 7 and the longitudinal flange 8. A fastening portion 10 is arranged on the lateral flange 7 and a retaining portion 9 is arranged on the longitudinal flange 8. A retaining recess 11 is provided by the retaining portion 9 and a fastening leg 12 is provided by the fastening portion 10.

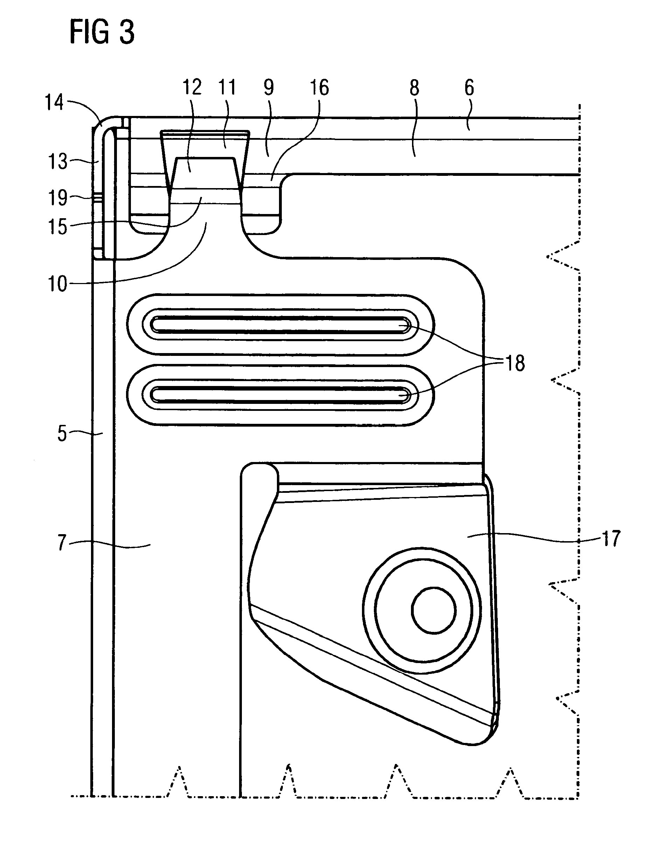

Fig 3 shows the embodiment according to Fig 2 in a closer view. The lateral flange 7 comprises a fastening portion 10, that is provided with a fastening leg 12. The fastening portion 10 is bent off at the bending of the fastening portion 15 into the interior of the casing 1, whereby the fastening leg 12 is defined by the part of the fastening portion 10, which is bent off. The longitudinal flange 8 comprises a retaining portion 9, that is provided with a retaining recess 11. The dimensions of the retaining recess 11 are adapted to the dimensions of the fastening leg 12. The retaining portion 9 is bent off at the bending of the retaining portion 16, whereby the retaining recess 11 is comprised partially within the part of the retaining portion 9, that is bent off. This part is also bent off into the interior of the casing 1.

The longitudinal wall 6 is provided with a joint flange 13, that that is bent off at the bending of the longitudinal wall 14. The joint flange 13 forms a butt joint 19 with the lateral wall 5. The lateral flange 7 comprises a connection element 17 for connecting the casing 1 to another component or to a household appliance. The connection element 17 comprises a hole for a screw connection, but also other connection methods can be provided. The lateral flange 7 furthermore comprises embossments 18 for stabilizing the casing 1, in particular for stabilizing the connection of the casing 1 to the household appliance.

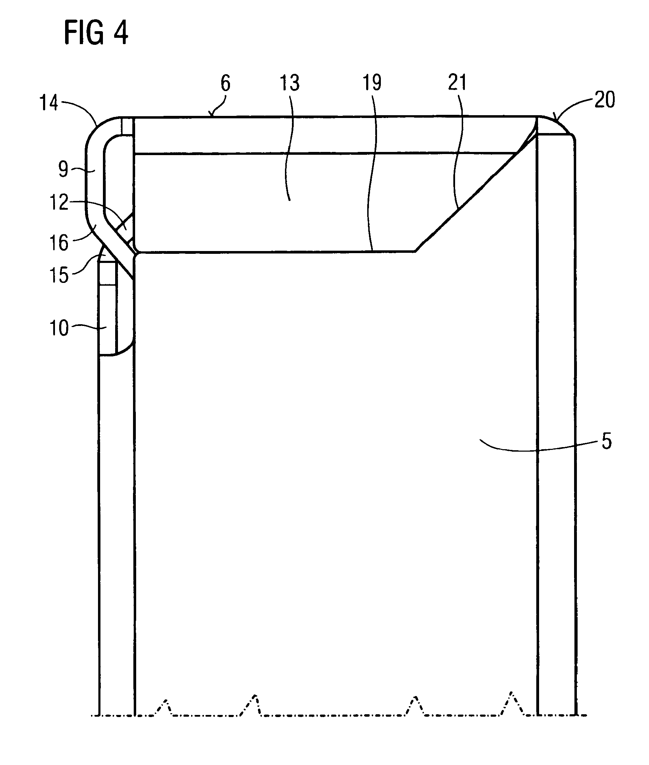

Fig 4 shows a wall view of a corner of the casing 1 embodying the invention. There is shown the lateral wall 5 and the longitudinal wall 6, wherein the longitudinal wall 6 is provided with a joint flange 13. The joint flange 13 is forming a butt joint 19 with the lateral wall 5. The joint flange 13 and the lateral wall 5 are cut in such a way that the butt joint 21 extends partially in a bevel 21 towards the upper front edge 20. The upper front edge 20 is formed by the front wall 2, the lateral wall 5 and the longitudinal wall 6. The retaining portion 9 and the bending of the retaining portion 16 are shown in cooperation with the fastening portion 10, the bending of the fastening portion 15 and the fastening leg 12. The fastening leg 12 engages into the retaining recess 11, which is not visible in this view, and thereby the fastening portion 15 is entangled with the retaining portion.

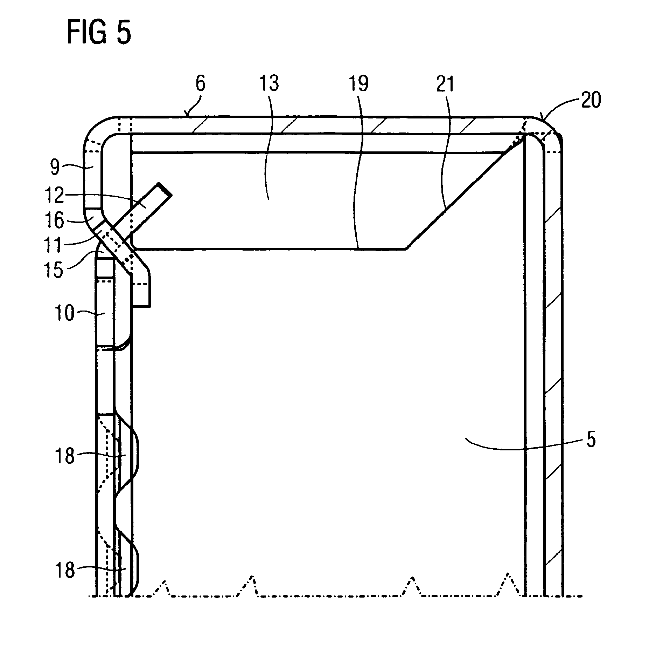

Fig 5 shows a sectional wall view of a corner of the casing 1 embodying the invention. As in Fig 4 there is shown the lateral wall 5 and the longitudinal wall 6 and the upper front edge 20. Because of the section the joint flange 13 and the butt joint 19 are now comprised corresponding on the other wall of the casing 1. The retaining portion 9 and the fastening portion 10 are now completely visible. The fastening leg 12 engages into the retaining recess 11. Depending on the dimensions of the fastening leg 12 and the retaining recess 11 as well as on their angles relative to the planes defined by the planar extension of the fastening portion 10 and the retaining portion 9, a force is applied by the fastening leg 12, when it is in contact with the retaining portion 9. This force causes a traction in such a way that the joint flange 13 and the lateral wall 5 are pressed together at the butt joint 19. When the force is strong enough, the butt joint 19 is provided without a gap. Furthermore there are shown embossments 18, that are comprised by the lateral flange 7.

The elements shown in the figures are designated as follows:
- 1: casing
- 2: front wall
- 3: back side
- 4: front side
- 5: lateral wall
- 6: longitudinal wall
- 7: lateral flange
- 8: longitudinal flange
- 9: retaining portion
- 10: fastening portion
- 11: retaining recess
- 12: fastening leg
- 13: joint flange
- 14: bending of the longitudinal wall
- 15: bending of the fastening portion
- 16: bending of the retaining portion
- 17: connection element
- 18: embossment
- 19: butt joint
- 20: upper front edge
- 21: bevel

## Claims

1. Casing (1) for a front cover of a household appliance, having at least one front wall (2), one longitudinal wall (6) and one lateral wall (5), wherein the front wall (2), the longitudinal wall (6) and the lateral wall (5) form a corner of the casing, the longitudinal wall (6) comprises a longitudinal flange (8) and a joint flange (13) which is bent off and forms a butt joint with the lateral wall (5) and the lateral wall (5) comprises a lateral flange (7) and wherein at least one retaining portion (9) is provided on one of the flanges and at least one fastening portion (10) is provided on the other flange, each flange (7, 8) is bent off rectangular and extending parallel to the front wall (2), such that the casing constitutes a box like form, where further
the fastening portion (10) comprises a fastening leg (12), arranged at an angle relative to planes defined by the flanges (7, 8) and the retaining portion (9) comprises a retaining recess (11) arranged at an angle relative to planes defined by the flanges (7, 8), whereas the fastening leg (12) engages into the retaining recess (11) and applies a force to the retaining portion (9), so that the lateral wall (5), the longitudinal wall (6) and the front wall (2) are fixed in their position relative to each other, wherein the force is applied by the fastening leg (12) when in contact with the retaining portion causing a traction such that the joint flange and the lateral wall are pressed together.

2. Casing according to one of the preceding claims, **characterized in that**
the lateral wall (5), the longitudinal wall (6) and the front wall (2) are fixed in a orthogonal position relative to each other.

3. Casing according to one of the preceding claims, **characterized in that**
the force is adjusted to the material the cover is made of.

4. Casing according to one of the preceding claims, **characterized in that**
the longitudinal wall (6) comprises a joint flange (13) that is bent off orthogonal into a recess comprised by the lateral wall (5) and that forms a butt joint (19) with the lateral wall (5).

5. Casing according to claim 4, **characterized in that** the force is adjusted in such a way, that the butt joint (19) is formed without a gap.

6. Casing according to one of the preceding claims, char acterized in that
the lateral flange (7) and/or the longitudinal flange (8) comprise one or more connection elements (17) for connecting electronic components or operating buttons or the like to the casing or for connecting the casing (1) to the household appliance.

7. Casing according to claim 6, **characterized in that** the connection element or connection elements for connecting the casing to another component or the household appliance are provided with at least one embossment (18) for stabilizing the connection.

8. Casing according to one of the preceding claims, char acterized in that
the bending of the longitudinal wall (14) and/or the upper front edge (20) comprise a radius of curvature equal or smaller than twice the thickness of the wall that is bent at this positions.

9. Casing according to one of the preceding claims, char acterized in that
the fastening leg (12) and the retaining recess (11) at least partially extend into the interior of the casing.

10. Casing according to one of the preceding claims, **characterized in that** the force that is applied by the fastening leg (12) to the retaining portion (9) is a predefined resilient force.

11. Method for forming a front cover of a household appliance, comprising the following steps:
- die cutting of one metal piece to a two-dimensional structure, wherein at least one retaining portion having a recess and one fastening portion having a fastening leg are produced
- bending the metal sheet for constituting a front wall, lateral walls, longitudinal walls, lateral flanges and longitudinal flanges, wherein at least one corner is constituted comprising the recess and the fastening leg, wherein each flange is bent off rectangular and extending parallel to the front wall such that the casing constitutes a box like form and wherein the longitudinal wall is provided with a joint flange which is bent off and forms a butt joint with the lateral wall
- engaging of the fastening leg into the recess by a bending operation, wherein a defined force is applied to the fastening leg, so that the joint between longitudinal wall and lateral wall is formed without a gap and wherein the force is applied by the fastening leg when in contact with the retaining portion causing a traction such that the joint flange and the lateral wall are pressed together

12. Method according to claim 11, wherein
the force to be applied to the fastening leg is defined after measuring dimensions and positions of the fastening leg and the recess.

## Patentansprüche

1. Gehäuse (1) für eine Frontabdeckung eines Haushaltsgeräts, umfassend mindestens eine Vorderwand (2), eine Längswand (6) und eine Seitenwand (5), wobei die Vorderwand (2), die Längswand (6) und die Seitenwand (5) eine Ecke des Gehäuses bilden, wobei die Längswand (6) einen Längsflansch (8) und einen Verbindungsflansch (13) umfasst, der abgebogen ist und eine Stoßverbindung mit der Seitenwand (5) bildet, wobei die Seitenwand (5) einen Seitenflansch (7) umfasst, wobei mindestens ein Rückhalteteil (9) an einem der Flansche vorgesehen ist und wobei mindestens ein Befestigungsteil (10) am anderen Flansch vorgesehen ist, wobei jeder Flansch (7, 8) rechtwinklig abgebogen ist und sich parallel zur Vorderwand (2) erstreckt, so dass das Gehäuse eine schachtelförmige Form aufweist, wobei darüber hinaus der Befestigungsteil (10) ein Befestigungsbein (12) umfasst, das in einem Winkel relativ zu den Ebenen angeordnet ist, die durch die Flansche (7, 8) definiert werden, wobei der Rückhalteteil (9) eine Rückhaltevertiefung (11) umfasst, die in einem Winkel relativ zu den Ebenen angeordnet ist, die durch die Flansche (7, 8) definiert werden, wobei das Befestigungsbein (12) in die Rückhaltevertiefung (11) eingreift und eine Kraft auf den Rückhalteteil (9) ausübt, so dass die Seitenwand (5), die Längswand (6) und die Vorderwand (2) in ihrer Position relativ zueinander fixiert werden, wobei die Kraft durch das Befestigungsbein (12) ausgeübt wird, wenn es in Kontakt mit dem Rückhalteteil ist, was einen Zug verursacht, so dass der Verbindungsflansch und die Seitenwand aneinandergepresst werden.

2. Gehäuse nach einem der vorhergehenden Ansprüche, **dadurch gekennzeichnet, dass**
die Seitenwand (5), die Längswand (6) und die Vorderwand (2) in einer rechtwinkligen Position relativ zueinander fixiert sind.

3. Gehäuse nach einem der vorhergehenden Ansprüche, **dadurch gekennzeichnet, dass**
die Kraft an das Material angepasst wird, aus dem die Abdeckung hergestellt ist.

4. Gehäuse nach einem der vorhergehenden Ansprüche, **dadurch gekennzeichnet, dass**
die Längswand (6) einen Verbindungsflansch (13) umfasst, der rechtwinklig in eine Vertiefung hinein gebogen ist, die durch die Seitenwand (5) gebildet wird, und der eine Stoßverbindung (19) mit der Seitenwand (5) bildet.

5. Gehäuse nach Anspruch 4, **dadurch gekennzeichnet, dass**
die Kraft derart eingestellt wird, dass die Stoßverbindung (19) ohne Zwischenraum gebildet wird.

6. Gehäuse nach einem der vorhergehenden Ansprüche, **dadurch gekennzeichnet, dass**
der Seitenflansch (7) und/oder der Längsflansch (8) ein oder mehrere Verbindungselemente (17) umfassen, um elektronische Bauteile oder Bedienungsknöpfe oder dergleichen mit dem Gehäuse zu verbinden oder um das Gehäuse (1) mit dem Haushaltsgerät zu verbinden.

7. Gehäuse nach Anspruch 6, **dadurch gekennzeichnet, dass**
das Verbindungselement oder die Verbindungselemente zur Verbindung des Gehäuses mit einem anderen Bauteil oder dem Haushaltsgerät mit mindestens einer Prägung (18) zur Stabilisierung der Verbindung versehen sind.

8. Gehäuse nach einem der vorhergehenden Ansprüche, **dadurch gekennzeichnet, dass**
die Krümmung der Längswand (14) und/oder der oberen Vorderkante (20) einen Krümmungsradius aufweist, der gleich dem Doppelten oder kleiner als das Doppelte der Dicke der Wand ist, die an dieser Position gebogen ist.

9. Gehäuse nach einem der vorhergehenden Ansprüche, **dadurch gekennzeichnet, dass**
sich das Befestigungsbein (12) und die Rückhaltevertiefung (11) mindestens teilweise in das Innere des Gehäuses erstrecken.

10. Gehäuse nach einem der vorhergehenden Ansprüche, **dadurch gekennzeichnet, dass**
die Kraft, die durch das Befestigungsbein (12) auf den Rückhalteteil (9) ausgeübt wird, eine vordefinierte Federkraft ist.

11. Verfahren zur Bildung einer Frontabdeckung für ein Haushaltsgerät, umfassend die folgenden Schritte:
- Formstanzen eines Metallteils zu einer zweidimensionalen Struktur, wobei mindestens ein Rückhalteteil mit einer Vertiefung und ein Befestigungsteil mit einem Befestigungsbein hergestellt werden;
- Biegen der Metallfolie, um eine Vorderwand, Seitenwände, Längswände, Seitenflansche und Längsflansche zu bilden, wobei mindestens eine Ecke gebildet wird, die die Vertiefung und das Befestigungsbein umfasst, wobei jeder Flansch rechtwinklig abgebogen ist und sich parallel zur Vorderwand erstreckt, so dass das Gehäuse eine schachtelförmige Form aufweist, und wobei die Längswand mit einem Verbindungsflansch versehen ist, der abgebogen ist und eine Stoßverbindung mit der Seitenwand bildet;
- Einfügen des Befestigungsbeins in die Vertiefung durch einen Biegevorgang, wobei eine definierte Kraft auf das Befestigungsbein ausgeübt wird, so dass die Verbindung zwischen der Längswand und der Seitenwand ohne Zwischenraum gebildet wird, und wobei die Kraft durch das Befestigungsbein ausgeübt wird, wenn es in Kontakt mit dem Rückhalteteil ist, was einen Zug verursacht, so dass der Verbindungsflansch und die Seitenwand aneinandergepresst werden.

12. Verfahren nach Anspruch 11, wobei
die auf das Befestigungsbein auszuübende Kraft festgelegt wird, nachdem die Abmessungen und Positionen des Befestigungsbeins und der Vertiefung gemessen wurden.

## Revendications

1. Boîtier (1) pour un recouvrement avant d'un appareil domestique, ayant au moins une paroi avant (2), une paroi longitudinale (6) et une paroi latérale (5), où la paroi avant (2), la paroi longitudinale (6) et la paroi latérale (5) forment un coin du boîtier, la paroi longitudinale (6) comprenant une bride longitudinale (8) et une bride de jonction (13) qui est pliée et forme un joint bout à bout avec la paroi latérale (5), et la paroi latérale (5) comprend une bride latérale (7), et où au moins une portion de retenue (9) est réalisée sur une des brides, et au moins une portion de fixation (10) est réalisée sur l'autre bride, chaque bride (7, 8) est pliée rectangulairement et s'étend parallèlement à la paroi avant (2) de telle sorte que le boîtier constitue une forme semblable à une boite, où en outre la portion de fixation (10) comprend une branche de fixation (12), agencée selon un angle relativement à des plans définis par les brides (7, 8), et la portion de retenue (9) comprend un évidement de retenue (11) agencé selon un angle relativement à des plans définis par les brides (7, 8), tandis que la branche de fixation (12) s'engage dans l'évidement de retenue (11) et applique une force à la portion de retenue (9) de sorte que la paroi latérale (5), la paroi longitudinale (6) et la paroi avant (2) sont fixées dans leur position les unes relativement aux autres, où la force est appliquée par la branche de fixation (12) lorsqu'elle est en contact avec la portion de retenue provoquant une traction de telle sorte que la bride de jonction et la paroi latérale sont pressées ensemble.

2. Boîtier selon l'une des revendications précédentes, **caractérisé en ce que** la paroi latérale (5), la paroi longitudinale (6) et la paroi avant (2) sont fixées dans une position orthogonale les unes relativement aux autres.

3. Boîtier selon l'une des revendications précédentes, **caractérisé en ce que** la force est ajustée au matériau à partir duquel le recouvrement est réalisé.

4. Boîtier selon l'une des revendications précédentes, **caractérisé en ce que** la paroi longitudinale (6) comprend une bride de jonction (13) qui est pliée orthogonalement dans un évidement compris par la paroi latérale (5) et qui forme un joint bout à bout (19) avec la paroi latérale (5).

5. Boîtier selon la revendication 4, **caractérisé en ce que** la force est ajustée de telle manière que le joint bout à bout (19) est formé sans espace.

6. Boîtier selon l'une des revendications précédentes, **caractérisé en ce que** la bride latérale (7) et/ou la bride longitudinale (8) comprennent un ou plusieurs éléments de connection (17) pour relier des composants électroniques ou des boutons d'actionnement ou analogue au boîtier ou bien pour relier le boîtier (1) à l'appareil domestique.

7. Boîtier selon la revendication 6, **caractérisé en ce que** l'élément de connection ou les éléments de connection pour relier le boîtier à un autre composant ou à l'appareil domestique présentent au moins un bossage (18) pour stabiliser la connection.

8. Boîtier selon l'une des revendications précédentes, **caractérisé en ce que** le pliage de la paroi longitudinale (14) et/ou du bord frontal supérieur (20) comprennent un rayon de courbure égal ou inférieur au double de l'épaisseur de la paroi qui est pliée à cette position.

9. Boîtier selon l'une des revendications précédentes, **caractérisé en ce que** la branche de fixation (12) et l'évidement de retenue (11) s'étendent au moins partiellement dans l'intérieur du boîtier.

10. Boîtier selon l'une des revendications précédentes, **caractérisé en ce que** la force qui est appliquée par la branche de fixation (12) à la portion de retenue (9) est une force résiliante prédéfinie.

11. Procédé de formation d'un couvercle frontal d'un appareil domestique, comprenant les étapes suivantes:
- découpage à la presse d'une pièce métallique en une structure bidimensionnelle, où au moins une portion de retenue ayant un évidement et une portion de fixation ayant une branche de fixation sont produites,
- plier la tôle pour former une paroi avant, des parois latérales, des parois longitudinales, des brides latérales et des brides longitudinales, où au moins un coin est formé comprenant l'évidement et la branche de fixation, où chaque bride est pliée d'une manière rectangulaire et s'étend parallèlement à la paroi frontale de telle sorte que le boîtier constitue une forme de boîte, et où la paroi longitudinale est munie d'une bride de jonction qui est pliée et forme un joint bout à bout avec la paroi latérale,
- engager la branche de fixation dans l'évidement par une opération de pliage, où une force définie est appliquée à la branche de fixation de telle sorte que la jonction entre la paroi longitudinale et la paroi latérale est formée sans espace, et où la force est appliquée par la branche de fixation lorsqu'elle est en contact avec la portion de retenue provoquant une traction telle que la bride de jonction et la paroi latérale sont pressées ensemble.

12. Procédé selon la revendication 11, dans lequel la force à appliquer à la branche de fixation est définie après la mesure des dimensions et des positions de la branche de fixation et de l'évidement.
